# EUROPÄISCHE PATENTSCHRIFT

(11) **EP 0 859 544 B1**
(45) Veröffentlichungstag und Bekanntmachung des Hinweises auf die Patenterteilung: **27.09.2000**
(21) Anmeldenummer: 98102460.7
(22) Anmeldetag: 12.02.1998
(51) Int. Cl.: H05K 13/04

(54) **Bestückungsautomat, Zuführeinheit für einen solchen Bestückungsautomaten, sowie Verfahren zur Steuerung eines solchen Bestückungsautomaten**
Mounting apparatus, supply unit for such a mounting apparatus and method for controlling such a mounting apparatus
Automate de placement, unité d'alimentation pour un tel automate de placement et procédé de contrôle d'un tel automate de placement

(30) Priorität: 18.02.1997 CH 36097
(43) Veröffentlichungstag der Anmeldung: 19.08.1998
(73) Patentinhaber: Zevatech Trading AG, 2545 Selzach (CH)
(72) Erfinder: Gfeller, Martin, CH 3314 Schalunen (CH); Christen, Otto, CH 4702 Oensingen (CH); Grunder, Emil, CH 4614 Hägendorf (CH)
(74) Vertreter: Falk, Urs, Dr.

(56) Entgegenhaltungen:
- DE-A- 3 805 781
- PATENT ABSTRACTS OF JAPAN vol. 97, no. 6, 30. Juni 1997 & JP 09 046088 A (CITIZEN WATCH CO LTD), 14. Februar 1997
- PATENT ABSTRACTS OF JAPAN vol. 11, no. 289 (M-625), 18. September 1987 & JP 62 083964 A (HITACHI LTD), 17. April 1987
- PATENT ABSTRACTS OF JAPAN vol. 12, no. 336 (M-739), 9. September 1988 & JP 63 097564 A (HITACHI LTD)

## Beschreibung

### TECHNISCHES GEBIET

Die vorliegende Erfindung bezieht sich auf das Gebiet der automatischen Bestückungstechnik. Sie betrifft einen Bestückungsautomaten mit wenigstens einer Zuführeinheit, welche herausnehmbar mit dem Bestückungsautomaten verbunden werden kann, und bei welcher Zuführeinheit ein Bauelemente für die Bestückung enthaltendes Band schrittweise zu einer Entnahmestelle transportiert wird, wo die Bauelemente nacheinander vom Bestückungsautomaten mittels eines durch eine Zentraleinheit des Bestückungsautomaten gesteuerten Pick-Up-Kopfes entnommen werden.

Die Erfindung betrifft weiterhin ein Verfahren zur Steuerung eines mit wenigstens einer herausnehmbaren Zuführeinheit ausgerüsteten Bestückungsautomaten, wobei in der Zuführeinheit ein Bauelemente für die Bestückung enthaltendes Band schrittweise zu einer Entnahmestelle transportiert wird, und die Bauelemente an der Entnahmestelle nacheinander vom Bestückungsautomaten mittels eines durch eine Zentraleinheit des Bestückungsautomaten gesteuerten Pick-Up-Kopfes entnommen werden.

### STAND DER TECHNIK

Die automatische Bestückung von elektronischen Schaltungen (PCBs oder dgl.) mittels Bestückungsautomaten ist seit langem bekannt und wird insbesondere dort eingesetzt, wo komplizierte und umfangreiche Schaltungen auch in grosser Stückzahl schnell, effizient und fehlerfrei mit einer grösseren Anzahl von Bauelementen bestückt werden müssen. Die Bauelemente liegen dabei nach Typen getrennt auf einzelnen Bändern vor, die auf Spulen aufgerollt sind und mittels entsprechender Zuführeinheiten (Feeder) schrittweise an einer Entnahmestelle (Pick-up position) vorbeigeführt werden, wo sie von einem Handhabungsautomaten entnommen und an dem zugewiesenen Platz in der Schaltung abgesetzt werden. Die Bauelemente sind dabei auf dem Band einzeln in periodisch hintereinander angeordneten Taschen untergebracht und üblicherweise durch ein darüberliegendes Deckband gegen Herausfallen oder Beschädigung geschützt. Derartige automatische Bestückungsvorrichtungen bzw. Bestückungsautomaten sind beispielsweise aus den US-Patenten 4,610,083, 4,653,664, 5,191,693, 5,289,625 und 5,515,600 bekannt.

Da die zu bestückenden elektronischen Schaltungen in der Regel eine Vielzahl von unterschiedlichen Bauelementen enthalten und für jedes Bauelement in der Regel eine einzelne Zuführeinheit am Bestückungsautomaten benötigt wird, werden die Zuführeinheiten (Feeder) platzsparend in möglichst schmaler Bauweise ausgeführt, damit eine möglichst grosse Anzahl von ihnen nebeneinander am Bestückungsautomaten eingesetzt und von der Entnahmevorrichtung (dem Pick-Up-Kopf) des Bestückungsautomaten in kurzer Zeit erreicht werden können (siehe dazu z.B. die Figuren aus der US-A-5,515,600 oder Fig. 13 aus der EP-A2-0 476 577). Die Mindestbreite der Zuführeinheit wird dabei massgeblich von der Breite des eingesetzten Bandes für die Bauelemente mitbestimmt.

Es kommt nun während des Betriebes eines solchen Bestückungsautomaten häufig vor, dass in einzelnen Zuführeinheiten die vorgehaltenen Bauelemente zur Neige gehen oder eine Zuführeinheit mit einem Bauelement-Typ gegen eine andere Zuführeinheit mit einem anderen Bauelement-Typ ausgetauscht werden soll. Zum Einsetzen neuer Bandspulen bzw. zum Austauschen der Zuführeinheiten müssen die betroffenen Zuführeinheiten, die an dem Bestückungsautomaten herausnehmbar eingesetzt bzw. eingesteckt sind, vom Bedienpersonal herausgenommen werden. Geschieht dies während des laufenden Bestückungsvorgangs, kann es passieren, dass der Pick-Up-Kopf an der betroffenen Zuführeinheit gerade einen Entnahmevorgang durchführt, oder die Zuführeinheit zwecks einer Bauelement-Entnahme gerade anfährt. In diesem Fall kann es zu einer Kollision zwischen dem Pick-Up-Kopf und der herausgenommenen Zuführeinheit kommen, die zu unerwünschten Beschädigungen an dem relativ empfindlichen Pick-Up-Kopf und auch an der Zuführeinheit führen kann. Selbst wenn der Bewegungsablauf des Pick-Up-Kopfes vom Bedienpersonal richtig abgepasst wird - was angesichts der hohen Geschwindigkeit des Pick-Up-Kopfes schwierig ist - kann es nach der Herausnahme der Zuführeinheit zu Fehlbestückungen kommen, wenn nämlich der Pick-Up-Kopf den leeren Platz der herausgenommenen Zuführeinheit anfährt. Zur Vermeidung dieser Probleme ist es zwar grundsätzlich denkbar, bei jedem Herausnehmen einer Zuführeinheit den Bestückungsvorgang zu unterbrechen und den Bestückungsautomaten anzuhalten. Jedoch führt eine solche Vorgehensweise zu erheblichen Verzögerungen im Bestückungsablauf, die im allgemeinen nicht tolerierbar sind.

### DARSTELLUNG DER ERFINDUNG

Es ist daher Aufgabe der Erfindung, einen Bestückungsautomaten und eine Zuführeinheit zu schaffen bzw. ein Verfahren zu seiner Steuerung anzugeben, bei welchen ein Auswechseln bzw. Herausnehmen einzelner Zuführeinheiten zu jedem Zeitpunkt auf einfache Weise sicher und Leistungsverlust für den Bestückungsprozess durchgeführt werden kann.

Die Aufgabe wird bei einem Bestückungsautomaten der eingangs genannten Art dadurch gelöst, dass Signalmittel vorhanden sind, welche beim Herausnehmen der Zuführeinheit aus dem Bestückungsautomaten ein Signal an die Zentraleinheit des Bestückungsautomaten abgeben. Durch das abgegebene Signal erhält die Zentraleinheit des Bestückungsautomaten automatisch und rechtzeitig Kenntnis von dem beginnenden Austauschvorgang an der Zuführeinheit. Sie kann daraufhin den Pick-Up-Kopf so steuern, dass er mit der herauszunehmenden Zuführeinheit nicht kollidiert. Befindet sich der Pick-Up-Kopf z.B. gerade über der Entnahmestelle der herauszunehmenden Zuführeinheit, kann er mittels seines schnellen Antriebs augenblicklich nach oben oder seitwärts verfahren werden, bevor es zu einer Kollision kommen kann. Befindet sich der Pick-Up-Kopf gerade auf dem Weg zur Entnahmestelle dieser Zuführeinheit, wird der Vorgang augenblicklich abgebrochen, so dass auch in diesem Fall eine Kollision sicher vermieden wird.

Eine erste bevorzugte Ausführungsform des Bestückungsautomaten nach der Erfindung zeichnet sich dadurch aus, dass zwischen der eingesetzten Zuführeinheit und dem Bestückungsautomaten eine Verbindung zum Austausch von Steuersignalen vorhanden ist, dass die Signalmittel in der Zuführeinheit angeordnet sind und das Herausnehm-Signal über die Verbindung an die Zentraleinheit des Bestückungsautomaten abgeben, dass die Signalmittel eine Schalteinrichtung umfassen, welche beim Herausnehmen der Zuführeinheit zwangsweise betätigt wird, dass die Zuführeinheit im eingesetzten Zustand am Bestückungsautomaten verriegelt ist, und dass die Signalmittel bzw. die Schalteinrichtung beim Entriegeln der Zuführeinheit automatisch betätigt werden. Hierdurch wird sichergestellt, dass der Pick-Up-Kopf genügend Zeit hat, auf die Herausnahme der Zuführeinheit zu reagieren.

Die erfindungsgemässe Zuführeinheit zeichnet sich dadurch aus, dass zur Verriegelung der Zuführeinheit an der dem Bestückungsautomaten zugewandten Seite der Zuführeinheit eine Einrastklinke vorgesehen ist, dass an der Aussenseite der Zuführeinheit ein Betätigungselement zur Betätigung der Einrastklinke angeordnet ist, dass die Betätigung der Einrastklinke durch das Betätigungselement über ein durch die Zuführeinheit geführtes Verbindungselement erfolgt und dass die Signalmittel in der Zuführeinheit angeordnet sind und mit der Einrastklinke, dem Betätigungselement oder dem Verbindungselement in Wirkverbindung stehen. Hierdurch kann auf einfache Weise die gewünschte Signalgebung in der Zuführeinheit realisiert werden.

Das Verfahren nach der Erfindung zeichnet sich dadurch aus, dass beim Herausnehmen der Zuführeinheit während eines laufenden Bestückungsvorgangs ein Signal erzeugt und an die Zentraleinheit des Bestückungsautomaten weitergeleitet wird, und dass die Zentraleinheit aufgrund des Herausnehm-Signals einen auf die Zuführeinheit bezogenen Bestückungsvorgang abbricht.

Gemäss einer bevorzugten Ausführungsform des erfindungsgemässen Verfahrens wird aufgrund des Herausnehm-Signals die herausgenommene Zuführeinheit bei der Zentraleinheit des Bestückungsautomaten abgemeldet und die Zuführeinheit nach der Abmeldung von dem Pick-Up-Kopf nicht mehr angefahren, setzt der Bestückungsautomat nach dem Abmelden der herausgenommenen Zuführeinheit die Bestückung mittels in de Bestückungsautomaten verbliebener Zuführeinheiten fort, wird beim Wiedereinsetzen der herausgenommenen Zuführeinheit ein Signal an die Zentraleinheit des Bestückungsautomaten abgegeben, welches die Zuführeinheit wieder anmeldet, und wird gegebenenfalls eine Nachbestückung mit Bauelementen aus der wieder eingesetzten Zuführeinheit durchgeführt. Hierdurch können Verzögerungen aufgrund des Auswechselns oder zeitweisen Herausnehmens einer Zuführeinheit ganz vermieden oder auf ein Minimum reduziert werden.

Weitere Ausführungsformen ergeben sich aus den abhängigen Ansprüchen.

### KURZE ERLÄUTERUNG DER FIGUREN

Die Erfindung soll nachfolgend anhand von Ausführungsbeispielen im Zusammenhang mit der Zeichnung näher erläutert werden. Es zeigen
- Fig. 1: in perpektivischer Seitenansicht ein bevorzugtes Ausführungsbeispiel für eine Zuführeinheit nach der Erfindung; und
- Fig. 2: ein schematisiertes Blockdiagramm für die Steuerung eines Bestückungsautomaten mit Zuführeinheit nach der Erfindung.

### WEGE ZUR AUSFÜHRUNG DER ERFINDUNG

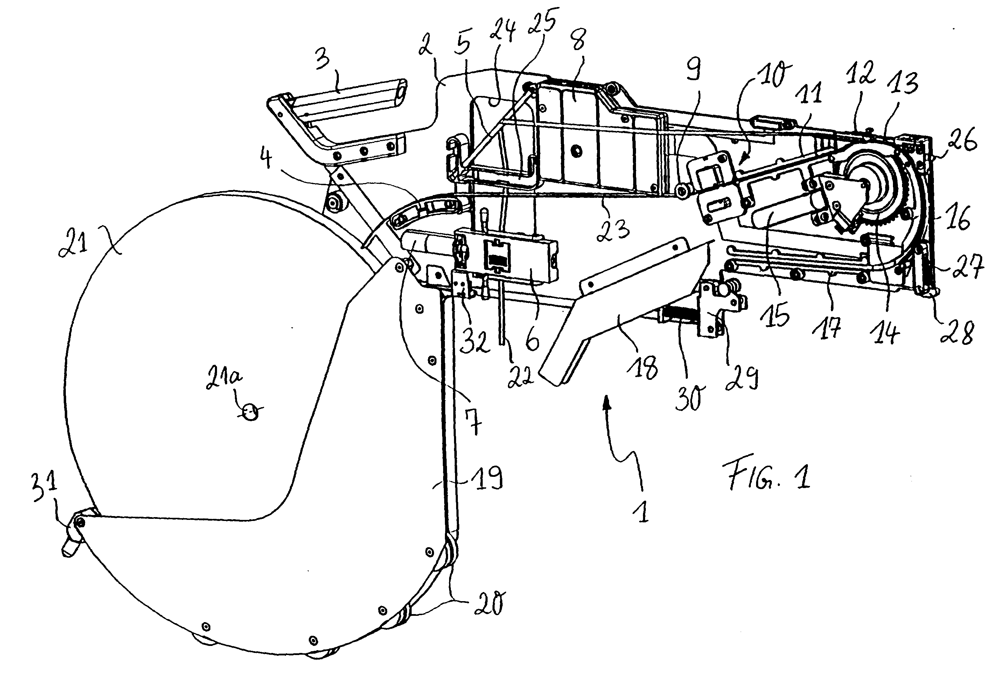

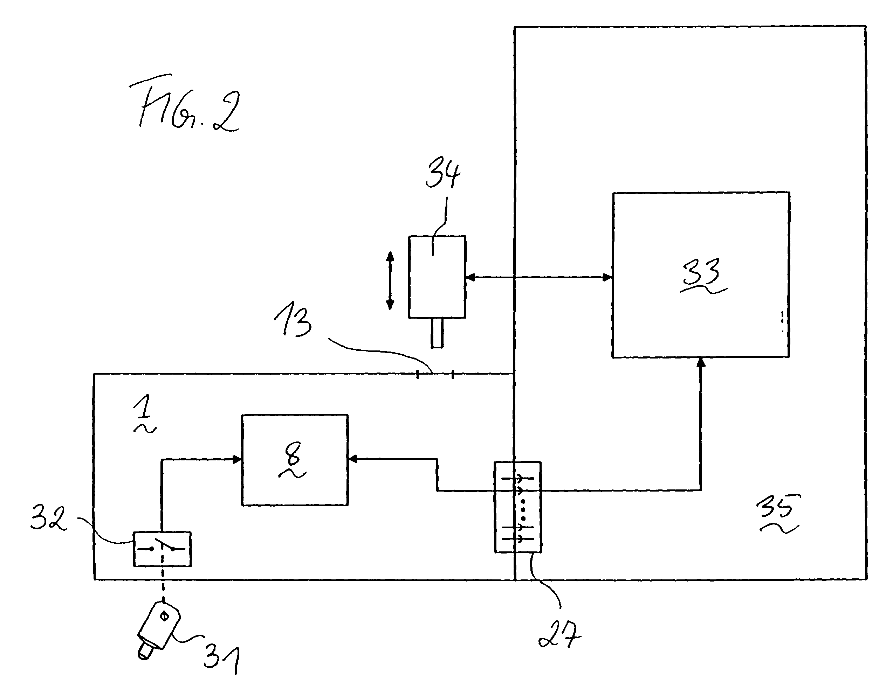

In der Fig. 1 ist in perspektivischer Seitenansicht ein bevorzugtes Ausführungsbeispiel einer erfindungsgemässen Zuführeinheit wiedergegeben. Die Zuführeinheit 1 ist auf einer Grundplatte 2 aus Metall aufgebaut, an welche eine Spulenaufnahme 19 angeschraubt ist. Die Spulenaufnahme 19 ist nach oben hin offen. In sie kann eine Spule 21 mit dem aufgerollten, die Bauelemente enthaltenden Band eingesetzt werden und sich auf mehreren am unteren Rand der Spulenaufnahme 19 angeordneten Laufrollen 20 frei drehen. Der Achse 21a der Spule 21 kommt dabei keine Funktion zu. Das Band 23 wird aus der Spule 21 heraus durch den zentralen Teil der Zuführeinheit 1 nach vorne geführt, wo an einer Entnahmestelle 13 eine (nicht dargestellte) Entnahmevorrichtung (Pick-Up-Kopf 34 in Fig. 2) eines (nicht dargestellten) Bestückungsautomaten (35 in Fig. 2) die Bauteile entnimmt.

Unterhalb der Entnahmestelle 13 ist ein von einem Antriebsmotor 15 angetriebenes Transportrad 14 angeordnet. Das Transportrad 14 ist als Zahnrad ausgebildet und greift mit seinen Zähnen in entsprechende Perforationen im Band 23 ein. Der Transport des Bandes 23 durch das Transportrad 14 erfolgt schrittweise und wird von einer elektronischen Steuereinheit 8 gesteuert, die in der Zuführeinheit 1 untergebracht ist. Die Führung des Bandes 23 aus der Spule 21 heraus zum Transportrad 14 hin erfolgt über ein erstes, leicht gekrümmtes Führungselement 4, eine Umlenkrolle 9 und einen ersten Führungskanal 11. Zwischen der Umlenkrolle 9 und dem Eingang des ersten Führungskanals ist ein (optischer) Bandsensor 10 vorgesehen, der zur Detektion des Bandendes oder des Endes eines Bandabschnitts verwendet wird.

Das Band 23 besteht aus einem mit Taschen für die Bauelemente versehenen Trägerband, welches durch ein aufgeklebtes Deckband verschlossen ist. Vor der Entnahmestelle 13 wird mittels einer Abziehvorrichtung 12, wie sie beispielhaft in der US-A-5,213,653 beschrieben ist, das Deckband 22 entgegen der Laufrichtung des Bandes 23 nach hinten abgezogen. Das Trägerband wird hinter der Entnahmestelle 13 durch einen zweiten, gebogenen Führungskanal 16 um das Transportrad 14 herum und durch einen dritten, geraden Führungskanal 17 nach hinten geführt und durch ein weiteres Führungselement 18 nach unten aus der Zuführeinheit 1 herausgelenkt.

Das abgezogene Deckband 22 läuft ohne weitere Führung an der Steuereinheit 8 vorbei zu einer Umlenkwelle 5 und wird dort nach unten umgelenkt und zugleich in der Bandachse um 90° gedreht, so dass die Fläche des Deckbandes 22 hinter der Umlenkwelle 5 in etwa parallel zur Grundplatte 2 orientiert ist. Die kombinierte Umlenkung und Drehung des Deckbandes wird dadurch erreicht, dass die Umlenkwelle 5 in der Ebene des Bandes 23 bzw. des Deckbandes 22 liegt, und dass die Umlenkwelle 5 mit der Laufrichtung des abgezogenen Deckbandes 22 einen Winkel von ungefähr 45° einschliesst.

Die Umlenkwelle 5 ist etwas oberhalb der Grundplatte 2 angeordnet. Damit das umgelenkte Deckband 22 leicht um die Umlenkwelle 5 gelegt und unterhalb der Umlenkwelle 5 sicher an dem dort vorbeilaufenden Band 23 vorbeigeführt werden kann, ist unter der Umlenkwelle 5 und im Bereich zwischen der Umlenkwelle 5 und der Antriebseinheit 6 in der Grundplatte 2 eine Aussparung 24 vorgesehen. Das Deckband 22 wird in seiner um 90° gedrehten Orientierung in der Aussparung 24 an dem Band 23 vorbeigeführt. Zur Führung des Deckbandes 22 in der Aussparung 24 ist ein Führungselement vorgesehen, welches insbesondere die Form eines quer zur Richtung des Deckbandes 22 angeordneten, feststehenden Bügels 25 hat.

Das abgezogene Deckband 22 wird mittels einer von einem separaten Antriebsmotor 7 angetriebenen Antriebseinheit 6 transportiert (gezogen), die unterhalb des Bügels 25 am unteren Rand der Aussparung 24 angeordnet ist. Die Antriebseinheit 6 für das Deckband 22 liegt in der Bandebene, d.h., die Antriebsachse verläuft parallel zur Bandebene bzw. zur Grundplatte 2. Zum Einlegen des Deckbandes 22 kann an der Antriebseinheit 6 in an sich bekannter Weise ein aufklappbares Oberteil geöffnet und anschliessend wieder geschlossen werden.

Die Zuführeinheit 1 wird mit dem vorderen Abschnitt, in welchem das Transportrad 14 angeordnet ist, in eine entsprechende Aufnahme im Bestückungsautomaten eingesteckt. Zur Führung und Zentrierung dienen dabei ein oben liegender Führungsstift 26 und eine an der Unterseite angeordnete Führungsnase 28. Eine Verbindung mit dem Bestückungsautomaten zum Austausch elektrische Signale wird durch einen zwischen Führungsstift 26 und Führungsnase 28 plazierten mehrpoligen Steckkontakt 27 hergestellt. Diese Konfiguration ist im wesentlichen bereits aus der US-A-5,024,720 der Anmelderin bekannt.

Die Unterkante der Grundplatte 2 weist im vorderen Bereich der Zuführeinheit 1 einen Absatz auf, an dem eine schwenkbare Einrastklinke 29 angeordnet ist, die mit einem hakenförmigen Fortsatz hinter ein Halteelement am Bestückungsautomaten greift und die Zuführeinheit 1 am Bestückungsautomaten in der eingesetzten Position verriegelt. Die Einrastklinke 29 wird über ein mechanisches Verbindungselement 30 in Form eines Bowdenzuges oder dgl. betätigt bzw. verschwenkt, welches aussen an der Spulenaufnahme 19 entlang zu einem drehhebelförmigen Betätigungselement 31 geführt ist. Das Betätigungselement 31 sitzt an der äusseren Spitze der Spulenaufnahme 19. Wenn es betätigt wird, schwenkt die Einrastklinke 29 in ihre Entriegelungsposition und die Zuführeinheit 1 kann mittels des Griffes 3 aus dem Bestückungsautomaten herausgenommen werden.

Durch die Betätigung des Betätigungselementes 31 wird - wie in Fig. 2 schematisch dargestellt ist - gleichzeitig mit der Entriegelung der Zuführeinheit 1 eine Schalteinrichtung 32 in der Zuführeinheit 1 betätigt, die ein Signal an die Steuereinheit 8 in der Zuführeinheit 1 abgibt. Dieses Signal wird von der Steuereinheit 8 über den Steckkontakt 27 an eine Zentraleinheit 33 in dem Bestückungsautomaten 35 weitergeleitet. Die Zentraleinheit 33 steuert daraufhin den Pick-Up-Kopf 34 des Bestückungsautomaten 35 augenblicklich aus dem Kollisionsbereich mit der Zuführeinheit 1 (wenn gerade eine Entnahme aus der Zuführeinheit 1 durchgeführt wurde) bzw. sorgt dafür, dass der Pick-Up-Kopf 34 nicht in den Kollisionsbereich verfahren wird (wenn gerade eine Entnahme aus der Zuführeinheit 1 geplant war). Der Kollisionsbereich befindet sich dabei in unmittelbarer Nähe der Entnahmestelle 13.

Gleichzeitig wird die herausgenommene Zuführeinheit 1 aufgrund des Herausnehm-Signals bei der Zentraleinheit 33 des Bestückungsautomaten 35 abgemeldet. Die Zuführeinheit 1 wird nach der Abmeldung dann von dem Pick-Up-Kopf 34 nicht mehr angefahren, so dass Fehlbestückungen aufgrund der nicht eingesetzten Zuführeinheit 1 sicher vermieden werden. Nach dem Abmelden der herausgenommenen Zuführeinheit 1 setzt der Bestückungsautomat 35 die Bestückung mittels anderer in dem Bestückungsautomaten 35 verbliebener Zuführeinheiten fort. Die Bauelemente aus der fehlenden Zuführeinheit werden dabei bewusst ausgelassen bzw. übergangen. Beim Wiedereinsetzen der herausgenommenen Zuführeinheit 1 wird dann ein Signal an die Zentraleinheit 38 des Bestückungsautomaten 35 abgegeben, welches die Zuführeinheit 1 wieder anmeldet. Aufgrund der Wiederanmeldung wird dann gegebenenfalls eine Nachbestückung mit Bauelementen aus der wieder eingesetzten Zuführeinheit 1 durchgeführt, so dass insgesamt ohne Zeitverlust die zu bestückende Schaltung komplett fertiggestellt wird.

Insgesamt ergibt sich mit der Erfindung ein Bestückungsautomat bzw. eine Zuführeinheit, sowie ein Verfahren zur Steuerung eines solchen Systems, welche die folgenden Merkmale und Vorteile aufweisen:
- Eine Zuführeinheit (Feeder) kann während des Bestückungsvorganges gefahrlos und kontrolliert aus dem Bestückungsautomaten entnommen werden
- Der Pick-Vorgang wird kontrolliert abgebrochen
- Die Zuführeinheit wird kontrolliert bei der Zentraleinheit des Bestückungsautomaten (Maschinenrechner) abgemeldet
- Es gibt keine Bestückungsfehler bei der Feeder-Entfernung aus dem Bestückungsautomaten während des Bestückungsprozesses
- Es gibt keinen Leistungsverlust, weil der Bestückungsautomat im Bestückungsprogramm definiert weiterfahren kann und eine Nachbestückung ausführt, sobald der fehlende Feeder wieder eingesteckt wird
- Es gibt keine Kollision mit dem Bestückungswerkzeug (Pick-Up-Kopf), weil der Pick-Vorgang kontrolliert unterbrochen wird.

### BEZEICHNUNGSLISTE

- 1: Zuführeinheit (Feeder)
- 2: Grundplatte
- 3: Griff
- 4: Führungselement (Band)
- 5: Umlenkwelle
- 6: Antriebseinheit (Deckband)
- 7: Antriebsmotor (Deckband)
- 8: Steuereinheit (elektronisch)
- 9: Umlenkrolle
- 10: Bandsensor
- 11,16,17: Führungskanal
- 12: Abziehvorrichtung (Deckband)
- 13: Entnahmestelle
- 14: Transportrad (Band)
- 15: Antriebsmotor (Band)
- 18: Führungselement (Trägerband)
- 19: Spulenaufnahme
- 20: Laufrolle
- 21: Spule
- 21a: Achse (Spule)
- 22: Deckband
- 23: Band
- 24: Aussparung
- 25: Bügel
- 26: Führungsstift
- 27: Steckkontakt
- 28: Führungsnase
- 29: Einrastklinke
- 30: Verbindungselement
- 31: Betätigungselement
- 32: Schalteinrichtung
- 33: Zentraleinheit (Bestückungsautomat)
- 34: Pick-Up-Kopf
- 35: Bestückungsautomat

## Patentansprüche

1. Bestückungsautomat (35) mit wenigstens einer Zuführeinheit (1), welche herausnehmbar mit dem Bestückungsautomaten (35) verbunden werden kann, und bei welcher Zuführeinheit (1) ein Bauelemente für die Bestückung enthaltendes Band (23) schrittweise zu einer Entnahmestelle (13) transportiert wird, wo die Bauelemente nacheinander vom Bestückungsautomaten (35) mittels eines durch eine Zentraleinheit (33) des Bestückungsautomaten (35) gesteuerten Pick-Up-Kopfes (34) entnommen werden, dadurch gekennzeichnet, dass Signalmittel (32) vorhanden sind, welche beim Herausnehmen der Zuführeinheit (1) aus dem Bestückungsautomaten (35) ein Signal an die Zentraleinheit (33) des Bestückungsautomaten (35) abgeben.

2. Bestückungsautomat nach Anspruch 1, dadurch gekennzeichnet, dass zwischen der eingesetzten Zuführeinheit (1) und dem Bestückungsautomaten (35) eine Verbindung (27) zum Austausch von Steuersignalen vorhanden ist, und dass die Signalmittel (32) in der Zuführeinheit (1) angeordnet sind und das Herausnehm-Signal über die Verbindung (27) an die Zentraleinheit (33) des Bestückungsautomaten (35) abgeben.

3. Bestückungsautomat nach Anspruch 1 oder 2, dadurch gekennzeichnet, dass die Signalmittel eine Schalteinrichtung (32) umfassen, welche beim Herausnehmen der Zuführeinheit (1) zwangsweise betätigt wird.

4. Bestückungsautomat nach einem der Ansprüche 1 bis 3, dadurch gekennzeichnet, dass die Zuführeinheit (1) im eingesetzten Zustand am Bestückungsautomaten (35) verriegelt ist, und dass die Signalmittel (32) beim Entriegeln der Zuführeinheit (1) automatisch betätigt werden.

5. Zuführeinheit für einen Bestückungsautomaten nach Anspruch 4, dadurch gekennzeichnet, dass zur Verriegelung der Zuführeinheit (1) an der dem Bestückungsautomaten (35) zugewandten Seite der Zuführeinheit (1) eine Einrastklinke (29) vorgesehen ist, dass an der Aussenseite der Zuführeinheit (1) ein Betätigungselement (31) zur Betätigung der Einrastklinke (29) angeordnet ist, dass die Betätigung der Einrastklinke (29) durch das Betätigungselement (31) über ein durch die Zuführeinheit (1) geführtes Verbindungselement (30) erfolgt, und dass die Signalmittel in der Zuführeinheit angeordnet sind und (32) mit der Einrastklinke (29), dem Betätigungselement (31) oder dem Verbindungselement (30) in Wirkverbindung stehen.

6. Verfahren zur Steuerung eines mit wenigstens einer herausnehmbaren Zuführeinheit (1) ausgerüsteten Bestückungsautomaten (35), wobei in der Zuführeinheit (1) ein Bauelemente für die Bestückung enthaltendes Band (23) schrittweise zu einer Entnahmestelle (13) transportiert wird, und die Bauelemente an der Entnahmestelle (13) nacheinander vom Bestückungsautomaten (35) mittels eines durch eine Zentraleinheit (33) des Bestückungsautomaten (35) gesteuerten Pick-Up-Kopfes (34) entnommen werden, dadurch gekennzeichnet, dass beim Herausnehmen der Zuführeinheit (1) während eines laufenden Bestückungsvorgangs ein Signal erzeugt und an die Zentraleinheit (33) des Bestückungsautomaten (35) weitergeleitet wird, und dass die Zentraleinheit (33) aufgrund des Herausnehm-Signals einen auf die Zuführeinheit (1) bezogenen Bestückungsvorgang abbricht.

7. Verfahren nach Anspruch 6, dadurch gekennzeichnet, dass beim Abbruch des Bestückungsvorganges der Pick-Up-Kopf (34) von der Zentraleinheit (33) in eine Position gesteuert wird, in welcher die Zuführeinheit (1) ohne Gefährdung des Pick-Up-Kopfes (34) aus dem Bestückungsautomaten (35) herausgenommen werden kann.

8. Verfahren nach einem der Ansprüche 6 oder 7, dadurch gekennzeichnet, dass aufgrund des Herausnehm-Signals die herausgenommene Zuführeinheit (1) bei der Zentraleinheit (33) des Bestückungsautomaten (35) abgemeldet wird und die Zuführeinheit (1) nach der Abmeldung von dem Pick-Up-Kopf (34) nicht mehr angefahren wird.

9. Verfahren nach Anspruch 8, dadurch gekennzeichnet, dass der Bestückungsautomat (35) nach dem Abmelden der herausgenommenen Zuführeinheit (1) die Bestückung mittels in dem Bestückungsautomaten verbliebener Zuführeinheiten fortsetzt, dass beim Wiedereinsetzen der herausgenommenen Zuführeinheit (1) ein Signal an die Zentraleinheit (38) des Bestückungsautomaten (35) abgegeben wird, welches die Zuführeinheit wieder anmeldet, und dass gegebenenfalls eine Nachbestückung mit Bauelementen aus der wieder eingesetzten Zuführeinheit (1) durchgeführt wird.

## Claims

1. A placement machine (35) with at least one feeder (1), which can be connected in a removable manner to the placement machine (35) and with which feeder (1) a tape (23) containing components for placement is transported in steps to a pick-up position (13), where the components are picked up by the placement machine (35) one after the other by means of a pick-up head (34) which is controlled by a central unit (33) of the placement machine (35), characterized in that a signal means (32) is provided which emits a signal to the central unit (33) of the placement machine (35) when the feeder is taken out of the placement machine (35).

2. A placement machine according to claim 1, characterized in that a connection (27) for the exchange of control signals is present between the inserted feeder (1) and the placement machine (35) and that the signal means (32) is located in the feeder (1) and emit the take out signal via the connection (27) to the central unit (33) of the placement machine (35).

3. A placement machine according to claim 1 or 2, characterized in that the signal means (32) comprises a switch device which is automatically actuated on the taking out of the feeder (1).

4. A placement machine according to one of claims 1 to 3, characterized in that in the inserted state the feeder (1) is locked on the placement machine (35) and in that the signal means (32) is automatically actuated when the feeder (1) is unlocked.

5. A feeder for a placement machine according to claim 4, characterized in that a snap-in latch (29) for the locking of the feeder (1) is present on the side of the feeder (1) facing the placement machine (35), that an actuating element (31) is arranged on the outside of the feeder (1) to actuate the snap-in latch (29), that the actuation of the snap-in latch (29) by the actuating element (31) is achieved via a connecting element (30) led through the feeder (1), and that the signal means (32) is located in the feeder and is in active connection with the snap-in latch (29), the actuating element (31) or the connecting element (30).

6. A method to control a placement machine (35) equipped with at least one removable feeder (1), whereby in the feeder (1) a tape (23) containing components for placement is transported in steps to a pick-up position (13) and whereby the components are picked at the pick-up position (13) one after the other by means of a pick-up head (34) which is controlled by a central unit (33) of the placement machine (35), characterized in that when the feeder is taken out during an on-going placement process a signal is generated and forwarded to the central unit (33) of the placement machine (35), and that the central unit (33) aborts any placement process relating to the feeder on the basis of the taking-out signal.

7. A method according to claim 6, characterized in that the pick-up head (34) is steered by the central unit (33) to a position where the feeder (1) can be taken out of the placement machine (35) without endangering the pick-up head (34) when the placement process is aborted.

8. A method according to one of claims 6 or 7, characterized in that on the basis of the take-out signal the feeder (1) which has been taken out is logged off with the central unit (33) of the placement machine (35) and that after the logging off the feeder (1) is no longer travelled to by the pick-up head (34).

9. A method according to claim 8, characterized in that after the logging off of the removed feeder (1) the placement machine (35) continues placement using the feeders remaining in the placement machine (35), that when the feeder (1) taken out is inserted back a signal is emitted to the central unit (33) of the placement machine (35) which logs the feeder back and that a subsequent placement with components from the feeder inserted back is performed, if necessary.

## Revendications

1. Automate d'équipement (35) comprenant au moins une unité d'alimentation (1) qui peut être reliée à l'automate d'équipement (35) de façon amovible et dans laquelle unité d'alimentation (1) une bande (23) contenant des composants destinés à l'équipement est transportée par pas successifs jusqu'à une zone de prélèvement (13) où les composants sont prélevés l'un après l'autre par l'automate d'équipement (35) au moyen d'une tête preneuse (34) commandée par une unité centrale (33) de l'automate d'équipement (35), caractérisé en ce qu'il est prévu des moyens de signaux (32) qui, lors de l'enlèvement de l'unité d'alimentation (1) de l'automate d'équipement (35), transmettent un signal à l'unité centrale (33) de l'automate d'équipement (35).

2. Automate d'équipement selon la revendication 1, caractérisé en ce qu'entre l'unité d'alimentation (1) mise en place et l'automate d'équipement (35), il existe une liaison (27) pour 1 'échange de signaux de commande et en ce que les moyens de signaux (32) sont agencés dans l'unité d'alimentation (1) et transmettent le signal d'enlèvement à l'unité centrale (33) de l'automate d'équipement (35) par l'intermédiaire de la liaison (27).

3. Automate d'équipement selon la revendication 1 ou 2, caractérisé en ce que les moyens de signaux comprennent un dispositif de commutation (32) qui est actionné positivement lors de l'enlèvement de l'unité d'alimentation (1).

4. Automate d'équipement selon une des revendications 1 à 3, caractérisé en ce que l'unité d'alimentation (1) est verrouillée sur l'automate d'équipement (35) dans l'état mis en place et en ce que les moyens de signaux (32) sont actionnés automatiquement lors du déverrouillage de l'unité d'alimentation (1).

5. Automate d'équipement selon la revendication 4, caractérisé en ce que, pour le verrouillage de l'unité d'alimentation (1), il est prévu un cliquet d'enclenchement (29) sur le côté de l'unité d'alimentation (1) qui est dirigé vers l'automate d'équipement (35), en ce qu'un élément d'actionnement (31) pour l'actionnement du cliquet d'enclenchement (29) est disposé sur le côté extérieur de l'unité d'alimentation (1), en ce que l'actionnement du cliquet d'enclenchement (29) est exécuté par l'élément d'actionnement (31) par l'intermédiaire d'un élément de liaison (30) qui passe à travers l'unité d'alimentation (1) et en ce que les moyens de signaux (32) sont disposés dans l'unité d'alimentation et sont en communication fonctionnelle avec le cliquet d'enclenchement (29), l'élément d'actionnement (31) ou l'élément de liaison (30).

6. Procédé pour la commande d'un automate d'équipement (35) équipé d'au moins une unité d'alimentation amovible (1) où, dans l'unité d'alimentation (1) , une bande (23) contenant des composants destinés à l'équipement est transportée par pas successifs jusqu'à une zone de prélèvement (13) et, dans la zone de prélèvement (13), les composants sont prélevés l'un après l'autre par l'automate d'équipement (35), au moyen d'une tête preneuse (34) commandée par une unité centrale (33) de l'automate d'équipement 35), caractérisé en ce que, lors de l'enlèvement de l'unité d'alimentation (1) pendant une opération d'équipement en cours, un signal est produit et transmis à l'unité centrale (33) de l'automate d'équipement (35) et en ce qu'en réponse au signal d'enlèvement, l'unité centrale (33) interrompt l'opération d'équipement relative à l'unité d'alimentation (1).

7. Procédé selon la revendication 6, caractérisé en ce que, lors de l'interruption de l'opération d'équipement, la tête preneuse (34) est envoyée par l'unité centrale (33) dans une position dans laquelle l'unité d'alimentation (1) peut être enlevée de l'automate d'équipement (35) sans danger pour la tête preneuse (34).

8. Procédé selon une des revendications 6 ou 7, caractérisé en ce qu'en réponse au signal d'enlèvement, l'unité d'alimentation (1) enlevée est déclarée enlevée auprès de l'unité centrale (33) de l'automate d'équipement (35) et, après cette déclaration d'enlèvement, l'unité d'alimentation (1) n'est plus approchée de la tête preneuse (34).

9. Procédé selon la revendication 8, caractérisé en ce qu'après la déclaration de l'unité d'alimentation (1) enlevée, l'automate d'équipement (35) continue l'équipement au moyen des unités d'alimentation qui sont restées dans l'automate d'équipement, en ce que, lors de la remise en place de l'unité d'alimentation (1) enlevée, un signal est envoyé à l'unité centrale (33) de l'automate d'équipement (35), signal qui annonce de nouveau l'unité d'alimentation, et en ce qu'il s'effectue éventuellement un équipement de reprise avec des composants issus de l'unité d'alimentation (1) remise en place.
